# EUROPÄISCHE PATENTSCHRIFT

(11) **EP 2 005 808 B1**
(45) Veröffentlichungstag und Bekanntmachung des Hinweises auf die Patenterteilung: **17.03.2010**
(21) Anmeldenummer: 06725721.2
(22) Anmeldetag: 12.04.2006
(51) Int. Cl.: H05K 13/00, H01L 21/683, H01L 21/00

(54) **VERFAHREN UND VORRICHTUNG ZUM ABLEGEN VON ELEKTRONISCHEN BAUTEILEN, INSBESONDERE HALBLEITERCHIPS AUF EINEM SUBSTRAT**
METHOD AND DEVICE FOR PLACING ELECTRONIC COMPONENTS, ESPECIALLY SEMICONDUCTOR CHIPS, ON A SUBSTRATE
PROCÉDÉ ET DISPOSITIF DE MISE EN PLACE DE COMPOSANTS ÉLECTRONIQUES, EN PARTICULIER DE PUCES À SEMI-CONDUCTEUR SUR UN SUBSTRAT

(43) Veröffentlichungstag der Anmeldung: 24.12.2008
(73) Patentinhaber: Kulicke & Soffa Die Bonding GmbH, 8572 Berg TG (CH)
(72) Erfinder: TRINKS, Joachim, CH-9230 Flawil (CH)
(86) Internationale Anmeldenummer: PCT/EP2006/061544
(87) Internationale Veröffentlichungsnummer: WO 2007/118511

(56) Entgegenhaltungen:
- WO-A-97/32460
- JP-A- 3 029 334
- JP-A- 60 016 433

## Beschreibung

Die Erfindung betrifft ein Verfahren zum Ablegen von elektronischen Bauteilen, insbesondere Halbleiterchips auf einem Substrat. Mit einem derartigen Verfahren wird beispielsweise bei der Herstellung von Halbleiterbauteilen in Chipmontageautomaten (Diebondern) der ungehäuste Chip von der bereits unterteilten Siliziumscheibe (Wafer) gepickt und dann auf entsprechende Substrate abgelegt bzw. gebondet. Nach dem Bondprozess folgen weitere Prozessschritte wie z.B. Aushärten, Wirebonding, Aufschmelzen von Lötverbindungen, Verkapseln, Vereinzeln, usw.

Für das Platzieren des Chips auf dem Substrat gibt es eine Vielzahl verschiedener Prozesse, wie z.B. Kleben, Löten oder Laminieren. Die Art des Verbindungsprozesses bestimmt auch, ob der Chip vor der Platzierung gewendet werden muss (Flipchip-Anwendungen) oder nicht (Nonflip-Anwendungen). Unter Wenden des Chips wird nachstehend ausdrücklich nicht eine Relativbewegung bezüglich einer Raumachse oder Raumebene verstanden, sondern ein Wenden in Bezug auf die ursprünglich Auflageseite. Im Falle von Nonflip Anwendungen wird der Chip nicht gewendet und nach der Aufnahme von der Waferfolie direkt in einem Schritt zum Substrat transportiert, wobei das Pickup-Werkzeug gleichzeitig auch als Bondwerkzeug verwendet wird. Die Auflageseite, mit der der Chip auf der Waferfolie aufgeklebt war, ist dann auch die Seite, mit der der Chip auf das Substrat aufgeklebt wird. Eine bekannte Vorrichtung dieser Art ist beispielsweise in EP 1 049 140 erwähnt oder durch die Firmenzeitschrift "Newsline 1/2002" der Anmelderin (Maschinentyp "Easyline") bekannt geworden. Im Falle von Flipchip Anwendungen wird der Chip mit seiner Strukturseite nach dem Wenden auf das Substrat abgesetzt, das heisst die Auflageseite, mit der der Chip auf der Waferfolie aufgeklebt war, ist nach dem Platzieren dann die dem Substrat abgewandte Seite. An modernen Diebondersysteme werden immer grössere Anforderungen gestellt bezüglich Herstellungskosten, Durchsatz, Genauigkeit und Prozessflexibilität. Trotzdem sollten die Maschinen bezüglich Bauhöhe, Maschinengrundriss, Gewicht usw. bestehende Vorrichtungen nicht übertreffen. Dies führt zu einer immer grösseren Komplexität der Maschinen hinsichtlich Mechanik, Bewegungsabläufe und Steuerung. Durch die US 2005/0132567 ist eine Vorrichtung bekannt geworden, bei welcher Halbleiterchips von einem drehbaren Pickwerkzeug mit drei Werkzeugköpfen aufgenommen werden und von dort auf eine höhere Ebene transportiert und von einem weiteren Werkzeug übernommen werden, das die Chips in einer linearen Bewegung über das Substrat führt und dort absetzt. Pickebene und Substratebene verlaufen parallel, jedoch auf unterschiedlichen Niveaus. Dadurch wird es möglich, dass der Wafertisch unter den Substrattisch gefahren werden kann, was ersichtlicherweise besonders bei grossen Wafern vorteilhaft ist, weil dadurch die Gesamtgrundfläche der Maschine klein gehalten werden kann. Allerdings wird hierbei der Chip durch die Übergabeoperation ersichtlicherweise immer gewendet, sodass er nicht mit seiner Auflageseite, sondern mit seiner Strukturseite auf das Substrat abgesetzt wird (Flipchip-Anwendung). Ausserdem benötigt das drehbare Pickwerkzeug zur Überwindung der Höhendifferenz zwischen der Pickebene und der Abgabeebene einen relativ grossen Aussendurchmesser, was sowohl bezüglich der Kinematik als auch aus Platzgründen nicht vorteilhaft ist.

Durch die WO 97/32460 ist eine Vorrichtung bekannt geworden, bei des ein Chip in zwei Arbeitstakten von einer Aufnahmeebene zu einer Abgabeebene transportiert wird. Dabei wird es an einer Zwischenstation abgesetzt und dort wahlweise geschwenkt oder gedreht.

Es ist daher eine Aufgabe der Erfindung, ein Verfahren der eingangs genannten Art zu schaffen, bei welchem die Höhendifferenz zwischen der Ebene der Vorratsstation und einer höher gelegenen Bereitstellungsebene mit geringerem Platzbedarf und kinematisch vorteilhafter überwunden werden kann und bei dem ausserdem Bauteile auch mit der gleichen Auflageseite wieder auf das Substrat abgesetzt werden können (Nonflip-Anwendung), wobei ein möglichst hoher Durchsatz mit einer verbesserten Absetzgenauigkeit erzielbar ist. Es soll ausserdem die Möglichkeit bestehen, bei Raumtemperatur zur picken, aber unter Umständen auch heiss platzieren zu können. Ausserdem soll es mit dem gleichen Verwahren bzw. mit der gleichen Vorrichtung möglich sein, sowohl Flipchip- als auch Nonflip-Anwendungen zu fahren, um das Einsatzspektrum mit geringen Mehrkosten erheblich zu verbreitern. Die Lage des Chips soll mit den entsprechenden optischen Bilderkennungseinrichtungen an verschiedenen Stellen möglichst optimal erfassbar sein. Schliesslich soll die Vorrichtung auch möglichst kompakt aufgebaut sein und einen möglichst kleinen Maschinengrundriss aufweisen. Diese Aufgabe wird in verfahrensmässiger Hinsicht mit einem Verfahren gelöst, das die Merkmale in Anspruch 1 aufweist. In vorrichtungsmässiger Hinsicht wird die Aufgabe mit einer Vorrichtung gelöst, welche die Merkmale im Anspruch 11 aufweist.

Wenn der Weg des Bauteils zwischen der Ebene der Vorratsstation und der Bereitstellungsebene in wenigstens zwei getrennten, aufsteigenden Kurvenbewegungen zurückgelegt wird, kann ersichtlicherweise bezogen auf den Grundriss Platz eingespart werden. Das Primärwerkzeug legt dabei mit dem Bauteil eine erste Kurvenbewegung zurück, übergibt das Bauteil in einer Übergabeposition wenigstens einem Schwenkwerkzeug, welches bis zur Bereitstellungsebene eine zweite Kurvenbewegung zurücklegt. Die Kurvenradien sind dabei wesentlich kleiner, als wenn der Hub des Bauteils durch ein einziges Drehwerkzeug zurückgelegt werden muss. Ausserdem müssen wesentlich kleinere Massen beschleunigt bzw. verzögert werden, was den Energieaufwand reduziert und schnellere Bewegungsabläufe ermöglicht. Bei entsprechend grossen Höhendifferenzen könnten selbstverständlich mehrere Schwenkwerkzeuge hintereinander geschaltet werden, so dass der Hub in mehr als zwei getrennten Schwenkbewegungen zurückgelegt würde. Ersichtlicherweise muss das wenigstens eine Schwenkwerkzeug im Wirkbereich des Primärwerkzeugs angeordnet sein.

Für eine Flipchip-Anwendung ist es besonders vorteilhaft, wenn das Primärwerkzeug das Bauteil einem Zwischenschwenkwerkzeug übergibt, welches das Bauteil an der Auflageseite erfasst und nach einer Schwenkbewegung einem Endschwenkwerkzeug übergibt, welches das Bauteil wiederum an der Strukturseite erfasst und in die Bereitstellungsebene schwenkt, wo es dem Sekundärwerkzeug übergeben wird, wobei es zuletzt mit der Strukturseite auf das Substrat abgesetzt wird. Das Zwischenschwenkwerkzeug übernimmt dabei ersichtlicherweise die Funktion, das Bauteil dem Endschwenkwerkzeug so zu übergeben, dass es an der Strukturseite erfasst werden kann. Nur unter dieser Bedingung, wird das Bauteil zuletzt vom Sekundärwerkzeug auch wieder mit der Strukturseite abgesetzt, wenn ein nochmaliges Wenden vermieden werden soll.

Dagegen ist es bei Nonflip-Anwendungen zweckmässig, wenn das Primärwerkzeug das Bauteil direkt einem Endschwenkwerkzeug übergibt, welches das Bauteil an der Auflageseite erfasst und in die Bereitstellungsebene schwenkt, wo es dem Sekundärwerkzeug übergeben wird, wobei es zuletzt wieder mit der gleichen Auflageseite auf das Substrat abgesetzt wird. Ersichtlicherweise bewirkt so bereits die Übergabe des Bauteils vom Primärwerkzeug an das Endschwenkwerkzeug, das es vom Sekundärwerkzeug an der Strukturseite erfasst und somit auch wieder mit der Auflageseite abgesetzt werden kann.

Besonders vielseitige Einsatzmöglichkeiten ergeben sich jedoch, wenn die Bauteile in einem ersten Betriebsmodus über das Zwischenschwenkwerkzeug und in einem zweiten Betriebsmodus direkt dem Endschwenkwerkzeug übergeben werden, wobei die Schwenkbewegung des Primärwerkzeugs im ersten bzw. im zweiten Betriebsmodus ausgehend von der Aufnahme an der Vorratsstation vorzugsweise auf separaten Bewegungsabschnitten z.B. Sektoren verläuft. Damit können wahlweise Flipchip-Anwendungen und Nonflip-Anwendungen gefahren werden. Die Ausführung der Schwenkbewegung des Primärwerkzeugs auf separaten Bewegungsabschnitten in Abhängigkeit vom gewählten Betriebsmodus ermöglicht eine optimale Anordnung des Zwischenschwenkwerkzeugs bzw. des Endschwenkwerkzeugs bzw. einen geometrisch optimalen Kurvenverlauf. Anstelle von Teilkreisbogenbewegungen könnten je nach Wahl der eingesetzten Getriebe jedoch auch andere Kurvenbewegungen gefahren werden, wie z.B. eine Zykloide oder eine Spirale. Die gegensinnig verlaufende Krümmung ermöglicht kurze Wege und eine möglichst direkte Überwindung des Hubs zwischen der Ebene der Vorratsstation und der Bereitstellungsebene. Die Bewegung des Sekundärwerkzeugs von der Übernahme des Bauteils bis über das Substrat verläuft vorteilhaft linear. Auch hier wäre allerdings eine gekrümmte Bewegung denkbar.

Eine besonders vorteilhafte Maschinenanordnung und Bewegungsführung ergibt sich, wenn der Transport des Bauteils von der Vorratsstation bis auf das Substrat im Wesentlichen auf einer etwa vertikalen Transportebene verläuft. Alle Antriebselemente und Hilfseinrichtungen können so ersichtlicherweise entlang dieser Ebene angeordnet werden. Dadurch wird auch die visuelle Beobachtung des Arbeitsablaufs und die Wartung der Maschine wesentlich vereinfacht. Weitere Vorteile können erreicht werden, wenn die Istlage (Position und Winkel) des Bauteils auf der Vorratsstation vor der Aufnahme mit einer ersten Bilderkennungseinrichtung ermittelt wird, und oder wenn die Istlage des Bauteils in der Bereitstellungsebene vor dem Transport zum Substrat mir einer zweiten Bilderkennungseinrichtung ermittelt wird, und/oder wenn die Istlage des Substrats mit einer dritten Bilderkennungseinrichtung ermittelt wird, wobei Abweichungen zwischen den ermittelten Istwerten und einer vorbestimmten Solllage des Bauteils vorzugsweise während des Transports korrigiert werden. Bei den Bilderkennungseinrichtungen kann es sich beispielsweise um CCD-Kameras handeln. Mit insgesamt nur drei solcher Kameras lässt sich dabei eine sehr hohe Präzision bzw. eine optimale Korrekturmöglichkeit erreichen. Je nach Anwendungsfall wäre es aber auch denkbar, beispielsweise lediglich die Istlage des Bauteils in der Bereitstellungsebene zu vermessen.

Im Hinblick auf die Möglichkeit der eingangs erwähnten unterschiedlichen Betriebsmodi ist es zweckmässig, wenn die Ermittlung der Istlage des Bauteils in der Bereitstellungsebene durch die zweite Bilderkennungseinrichtung im ersten Betriebsmodus von unten nach oben gegen das am Sekundärwerkzeug gehaltene Bauteil und im zweiten Betriebsmodus von oben nach unten gegen das am Endschwenkwerkzeug gehaltene Bauteil erfolgt. Damit ist gewährleistet, dass unabhängig vom Betriebsmodus in der Bereitstellungsebene das Bauteil immer an der Strukturseite vermessen werden kann.

Die Ermittlung der Istlage erfolgt vorteilhaft mit je einer der Bilderkennungseinrichtungen immer dann, wenn das Primärwerkzeug bzw. das Sekundärwerkzeug bzw. das Endschwenkwerkzeug das Bildfeld der zu ermittelnden Istlage freigibt. Transportbewegung und $ilderkennung laufen somit derart ab, dass sie sich gegenseitig nicht behindern.

Weitere Vorteile können erreicht werden, wenn die erste Bilderkennungseinrichtung derart angeordnet ist, dass die Erfassung des ihr zugeordneten Bildfeldes in beiden Betriebsmodi von innerhalb des Schwenkbereichs des Primärwerkzeugs erfolgt. Ebenso kann die zweite Bilderkennungseinrichtung für den zweiten Betriebsmodus derart angeordnet sein, dass die Erfassung des ihr zugeordneten Bildfeldes von innerhalb des Schwenkbereichs des Endschwenkwerkzeugs erfolgt. Die erste und die zweite Bilderkennungseinrichtung bzw. deren optische Achsen an der Ausgangsöffnung können dabei auf zueinander versetzten vertikalen Achsen angeordnet sein. Auch eine andere Anordnung wäre aber möglich, beispielsweise wenn die Drehachsen des Primärwerkzeugs und des Endschwenkwerkzeugs auf einer gemeinsamen Vertikalen liegen.

Die dritte Bilderkennungseinrichtung für das Erkennen der Istlage des Substrats kann an einem vorzugsweise linear verschiebbaren Schlitten angeordnet sein. Damit kann die Kamera unabhängig von der jeweiligen Stellung des Sekundärwerkzeugs in eine Beobachtungsposition gefahren werden. Dies vereinfacht die Konstruktion der Substratzuführung. Bei Substraten mit matrixartiger Anordnung von Absetzpositionen müssen die Substrate nämlich nur in eine Richtung (x) verschoben werden, während die andere Richtung (y) von der in diese Raumrichtung bewegbaren Bilderkennungseinrichtung und dem ebenso in dieser Raumrichtung bewegbaren Sekundärwerkzeug erreichbar ist. Zudem erhöht dies ersichtlicherweise die Flexibilität der Abläufe und verbessert so den Durchsatz, da die Messung entkoppelt von der Position des Sekundärwerkzeugs erfolgen kann und damit Prozesse parallelisiert werden können. Für hochgenaue Anwendungen kann es aber auch zweckmässig sein, die dritte Bilderkennungseinrichtung direkt am Schlitten des Sekundärwerkzeugs anzuordnen.

Weitere Vorteile können erreicht werden, wenn die Ablagestation als Transportstation für den vorzugsweise linearen Durchlauf einer Mehrzahl von Substraten ausgebildet ist. Als Transportmittel können dabei an sich bekannte Klemmeinrichtungen, Förderbänder oder dergleichen eingesetzt werden.

Neben der Vorratsstation kann eine Waferkassette angeordnet sein, welche zum Laden von Waferframes auf die Vorratsstation in verschiedene Ladepositionen bewegbar ist, in denen die Vorratsstation und die Waferkassette wenigstens teilweise auf der gleichen Ebene angeordnet sind, wobei die Waferkassette in eine Ruheposition bewegbar ist, in welcher die Vorratsstation zum Abarbeiten eines geladenen Waferframes wenigstens teilweise in der horizontalen Arbeitsebene über die Waferkassette verschiebbar ist. Ersichtlicherweise kann so die Waferkassette sehr Platz sparend angeordnet werden, ohne dass ihre Funktion beim Beladen der Arbeitsstation beeinträchtigt wird.

Weitere Vorteile können schliesslich auch noch erreicht werden, wenn im Schwenkbereich des Primärwerkzeugs und/oder des Endschwenkwerkzeugs eine oder mehrere Zwischenablagestationen angeordnet sind, an denen ein Bauteil vor der Übergabe an das Sekundärwerkzeug vorübergehend ablegbar ist. Ersichtlicherweise können so einzelne Bauteile vorübergehend aus dem Arbeitsprozess ausgeschieden und zwischengelagert werden, um zu einem späteren Zeitpunkt wieder weiterverarbeitet zu werden. Im Hinblick auf die heutigen Qualitätsanforderungen bei der Fertigung ist es nämlich teilweise erforderlich, beispielsweise Chips qualitätsmässig zu differenzieren. Um eine möglichst hohe Ausbeute zu erhalten, kann es erforderlich sein, dass nur qualitativ hochwertige Chips auf qualitativ hochwertige Substratpositionen abgesetzt werden, wobei qualitativ schlechtere Chips auf qualitativ schlechteren Substratpositionen eingesetzt werden können. Die Zwischenablagestation ermöglicht auf besonders einfache Weise eine qualitative Steuerung des Ablageprozesses.

Ersichtlicherweise sind verschiedene Ausgestaltungen der Erfindung denkbar, ohne den Gegenstand des Schutzbereichs zu verlassen. So könnten z.B. zwei getrennte Endschwenkwerkzeuge Bauteile von einem gemeinsamen Primärwerkzeug übernehmen und an zwei getrennte Sekundärwerkzeuge übergeben.

Weitere Einzelmerkmale und Vorteile der Erfindung ergeben sich aus der nachfolgenden Beschreibung eines Ausführungsbeispiels und aus den Zeichnungen. Es zeigen:
- Figur 1: Eine vereinfachte Darstellung eines unterteilten Wafers mit einem vergrössert dargestellten Halb- leiterchip,
- Figur 2: eine perspektivische Gesamtdarstellung einer Vorrichtung,
- Figur 3: eine stark vereinfachte Seitendarstellung der Vorrichtung gemäss Figur 2 mit einer Waferkasset- te in Ruhestellung,
- Figur 4: die Vorrichtung gemäss Figur 3 mit der Waferkas- sette in der untersten Zufuhrstellung,
- Figur 5: die Vorrichtung gemäss Figur 3 mit der Waferkas- sette in der obersten Zufuhrstellung,
- Figur 6: eine perspektivische Darstellung eines Primär- werkzeugs, eines Zwischenschwenkwerkzeugs und ei- nes Endschwenkwerkzeugs sowie eines Sekundärwerk- zeugs,
- Figur 7: eine schematische Darstellung des Kurvenverlaufs der Werkzeuge an der Vorrichtung gemäss Figur 6,
- Figur 8: eine Seitendarstellung der ersten Bilderkennungs- einrichtung am Primärwerkzeug,
- Figur 9: eine Seitendarstellung der zweiten Bilderkennungseinrichtung am Endschwenkwerkzeug,
- Figur 10: eine Frontalansicht der beiden Bilderkennungseinrichtungen gemäss den Figuren 8
- Figur 11a-l1e: und verschiedene Sequenzen eines Arbeitsvorgangs ohne Wenden des Bauteils, und
- Figur 12a-12e: verschiedene Sequenzen eines Arbeitsvorgangs mit Wenden des Bauteils.

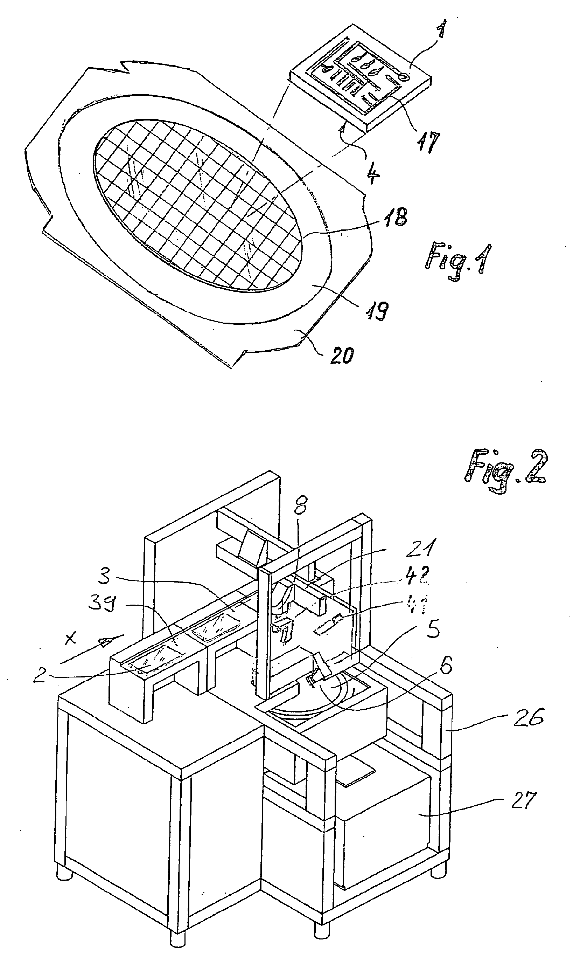

In Figur 1 ist stark vereinfacht eine an sich bekannte Anordnung dargestellt, bei welcher ein bereits unterteilter Halbleiterwafer 18 auf eine Waferfolie 19 geklebt ist, die ihrerseits in einem Waferframe 20 gespannt ist. Die Halbleiterchips 1 sind bereits durch die Sägelinien vereinzelt, was durch die sich kreuzenden Linien angedeutet ist. Jeder Chip 1 verfügt über eine Auflageseite 4, mit welcher er vor dem Ablösen auf der Waferfolie 19 haftet. Auf der der Auflageseite 4 gegenüberliegenden Seite ist Halbleiterstruktur aufgebracht, weshalb sie nachstehend als Strukturseite 17 bezeichnet wird. Falls es sich beim elektronischen Bauteil nicht um einen Halbleiterchip handelt, entspricht die Strukturseite jeweils einfach der Oberseite des Bauteils. Das Vereinzeln der Chips durch Sägen bzw. der Ablösevorgang von der Waferfolie mit Hilfe von Nadeln und anderen Hilfsmitteln sind dem Fachmann bereits hinreichend bekannt.

Zunächst werden anhand von Figur 2 die wesentlichen funktionellen Einheiten einer Vorrichtung beschrieben. Auf einem Maschinengestell ist eine Vorratsstation 5 angeordnet, welche im vorliegenden Fall als Wafertisch für die Aufnahme von vorbereiteten Waferframes gemäss Figur 1 ausgebildet ist. Die Vorratsstation kann auf einer horizontalen Ebene in zwei Raumachsen verschoben werden, so dass jeder einzelne Chip in eine Ablöseposition gefahren werden kann. Aus einer Waferkassette 27, welche hier in die Ruheposition abgesenkt ist, können bei Bedarf weitere Waferframes nachgeschoben werden. Die Ablagestation 3, zu welcher die Bauteile von der Vorratsstation transportiert werden müssen, ist hier als Zufuhrsystem 39 ausgebildet, auf welchem in Pfeilrichtung x Substrate 2 taktweise zugeführt werden können.

Die einzelnen Chips werden von einem Primärwerkzeug 6 von der Vorratsstation 5 abgehoben und hoch geschwenkt und danach alternativ einem Zwischenschwenkwerkzeug 41 oder direkt einem Endschwenkwerkzeug 42 übergeben. Letzteres übergibt den Chip dem Sekundärwerkzeug 8, das entlang einer Schlittenführung 21 bis über die Ablagestation 3 verschiebbar ist.

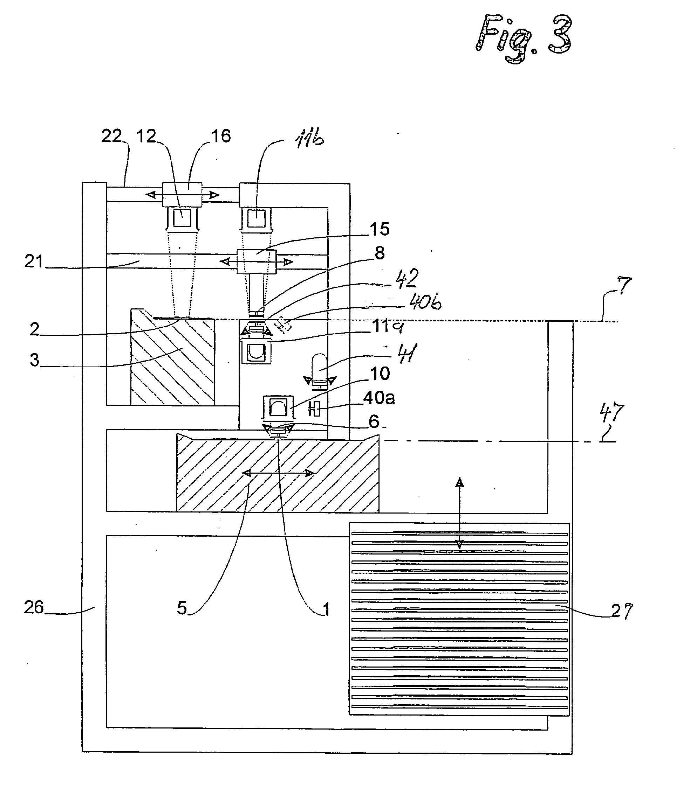

Weitere Einzelheiten der Vorrichtung sind aus Figur 3 ersichtlich. Für den Transport der einzelnen Chips 1 muss zunächst eine Höhendifferenz zwischen der Ebene 47 der Vorratsstation und der Bereitstellungsebene 7 überwunden werden, welche praktisch zusammenfällt mit der Ebene der Ablagestation 3 mit den Substraten 2. Diese Höhendifferenz wird auf nachstehend noch genauer beschriebene Art und Weise durch wenigstens zwei Schwenkbewegungen des Primärwerkzeugs 6 bzw. des Endschwenkwerkzeugs 42 und gegebenenfalls noch durch eine dazwischen liegende Schwenkbewegung des Zwischenschwenkwerkzeugs 41 zurückgelegt. Das Sekundärwerkzeug 8 ist an einem Schlitten 15 befestigt, welcher linear auf einer Führungsschiene 21 verschiebbar ist. Am Sekundärwerkzeug sind Korrekturbewegungen in den x- und y- Achsen sowie um eine Drehachse vor dem Absetzten des Bauteils möglich, wenn dies aufgrund der Ermittlung der Istlage erforderlich ist.

Die verschiedenen Arbeitswerkzeuge sind mit Aufnahmewerkzeugen zum Festhalten eines Bauteils z.B. mittels Unterdruck versehen. Diese Aufnahmewerkzeuge können vorzugsweise noch wenigstens eine weitere Bewegung in ihrer Längsachse und/oder um ihre Längsachse ausführen.

Im Schwenkbereich des Primärwerkzeugs 6 bzw. des Endschwenkwerkzeugs 42 ist je eine Zwischenablagestation 40a bzw. 40b angeordnet. Wie eingangs erwähnt, dienen diese Zwischenstationen dazu, einen Chip vorübergehend in einer Warteposition zu platzieren, um ihn zu einem späteren Zeitpunkt weiter zu transportieren. Ähnlich wie die Arbeitswerkzeuge für den Transport der Bauteile sind auch die Zwischenablagestationen mit Aufnahmewerkzeugen versehen.

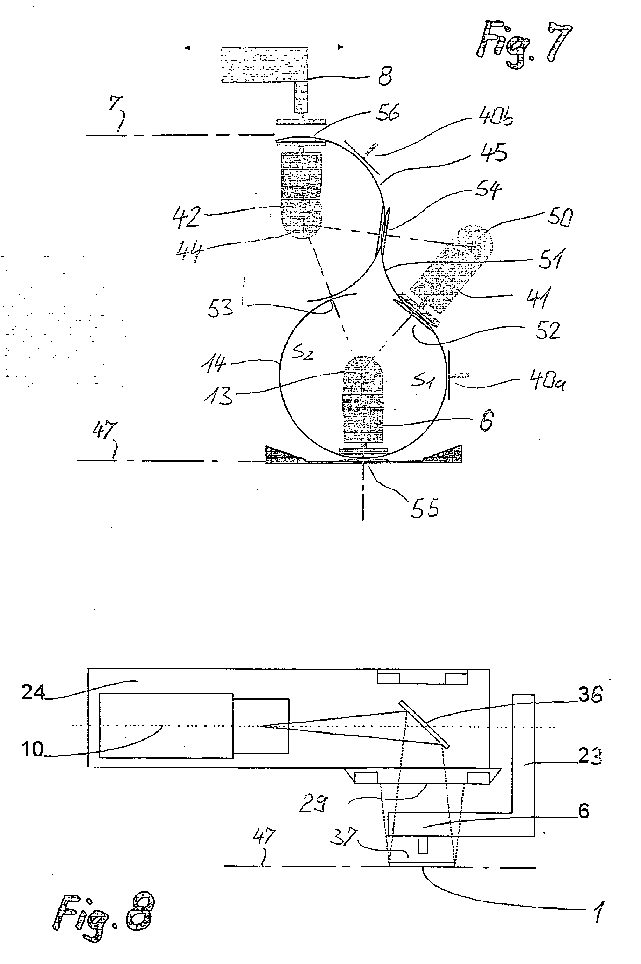

Für die Überwachung und Korrektur verschiedener Istlagen sind verschiedene Kameras an der Vorrichtung angeordnet. Eine erste Kamera 10 ermittelt die Istlage eines Chips 1 an der Vorratsstation 5 vor dem Abheben. Eine zweite untere Kamera 11a erkennt die Lage eines Chips bei bereits erfolgter Übergabe an das Sekundärwerkzeug 8. Eine zweite obere Kamera 11b erkennt dagegen die Lage eines Chips am Endschwenkwerkzeug 42 vor der Übergabe an das Sekundärwerkzeug 8. Ersichtlicherweise wird alternativ eine der beiden zweiten Kameras 11a oder 11b aktiviert, je nach dem, ob das Sekundärwerkzeug den Chip an der Auflageseite oder an der Strukturseite erfasst. Schliesslich vermag eine dritte Kamera 12 die Istlage des Substrats 2 auf der Ablagestation 3 zu erkennen. Diese dritte Kamera 12 ist an einem Schlitten 16 angeordnet, der entlang einer Führungsschiene 22 verschiebbar ist. Weitere Einzelheiten zu diesen Komponenten ergeben sich aus den Figuren 8 bis 10.

Da die Ablagestation 3 und die Vorratsstation 5 auf unterschiedlichen Ebenen liegen, lässt sich ersichtlicherweise die Vorratsstation 5, also der Wafertisch im Hinblick auf seinen Bewegungsbereich unter die Ablagestation, also unter das Zufuhrsystem schieben, womit der Grundriss des Maschinengestells 26 sehr klein gehalten werden kann. Die Vorratsstation 5 muss in zwei Raumachsen horizontal verschiebbar sein, da jeder einzelne abzuhebende Chip jeweils exakt unter das abhebende Primärwerkzeug 6 zu fahren ist. Derartige Steuerungen sind dem Fachmann bereits bekannt.

Aus den Figuren 3 bis 5 sind weitere Einzelheiten zur Verschiebbarkeit der Vorratsstation 5 in Kombination mit der Waferkassette 27 ersichtlich. Die Waferkassette 27 verfügt auf an sich bekannte Weise über verschiedene Einschubfächer, wobei in jedem Fach ein vorbereiteter Waferframe mit unterteiltem Wafer (gemäss Figur 1) enthalten ist. Die Waferkassette ist vertikal bewegbar und ein hier nicht näher dargestellter Entnahmemechanismus kann aus jeder Etage einen Waferframe entnehmen und auf die Vorratsstation 5 transferieren. Gemäss Figur 3 ist die Waferkassette 27 unter das Niveau der Vorratsstation abgesenkt. In dieser Position kann die in zwei Raumachsen verschiebbare Vorratsstation 5 sowohl unter die Ablagestation 3 als auch über die Waferkassette 27 geschoben werden, womit ersichtlicherweise der Maschinengrundriss sehr klein gehalten werden kann.

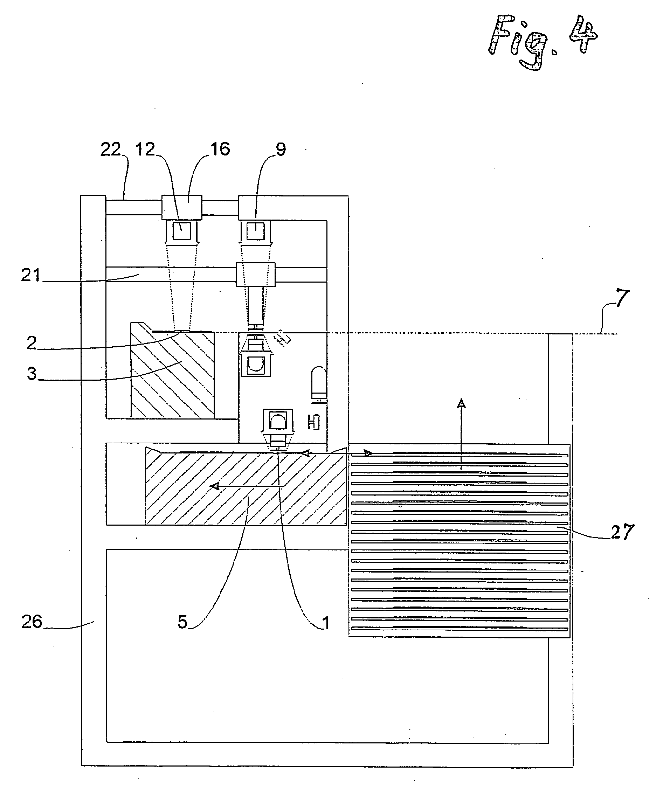

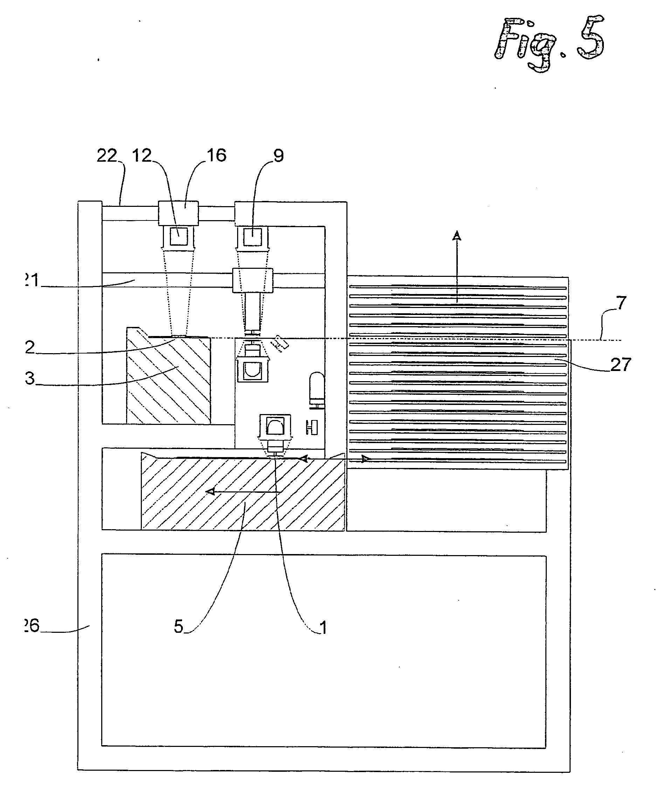

Gemäss Figur 4 steht die Waferkassette 27 in der untersten Entladeposition, in welcher aus der obersten Etage ein Waferframe entnommen werden kann. In der Folge wird jedes Mal, wenn ein Waferframe leer gepickt ist, dieser in die entsprechende leere Etage zurückgeschoben und aus der nächsten Etage ein neuer Waferframe entnommen, bis die letzte Etage erreicht ist. Dabei befindet sich die Waferkassette 27 in der obersten Entnahmeposition, was in Figur 5 dargestellt ist. Selbstverständlich wird die Waferkassette 27 nach jedem Lade- bzw. Entladevorgang wieder in die Ruheposition gemäss Figur 3 abgesenkt.

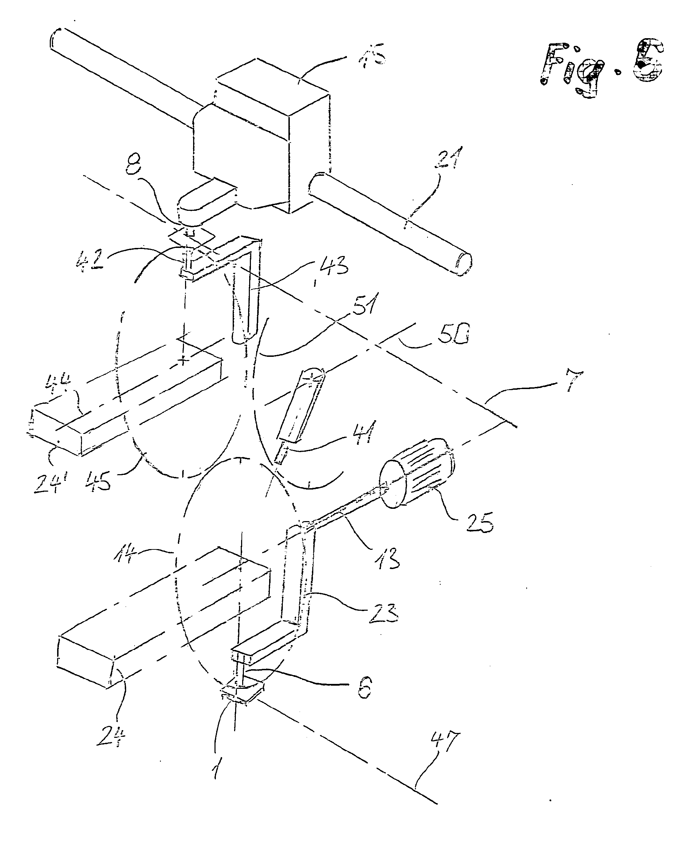

Figur 6 zeigt weitere Einzelheiten der gesamten Transportvorrichtung. Das Primärwerkzeug 6 ist dabei am Ende und auf der Aussenseite eines L-förmigen Dreharms 23 angeordnet. Der Dreharm dreht sich um eine horizontale Achse 13 und ist über einen Motor 25 drehantreibbar. Das Primärwerkzeug beschreibt dabei einen Drehkreis bzw. Teilkreis 14, wobei der Motor 25 eine Betätigung in beide Drehrichtungen ermöglicht. Ein nachstehend noch beschriebenes Kameragehäuse 24 mit einem Objektivausgang ist innerhalb des Drehkreises 14 angeordnet. Auf gleiche oder ähnliche Weise ist das Endschwenkwerkzug 42 an einem L-förmigen Dreharm 43 um eine Achse 44 auf einem Drehkreis 45 schwenkbar. Auch hier ragt ein Kameragehäuse 24' ins Innere des Drehkreises 45, jedoch mit einem nach oben gerichteten Objektivausgang.

Schliesslich ist im Wirkbereich des Primärwerkzeugs 6 bzw. des Endschwenkwerkzeugs 42 noch ein Zwischenschwenkwerkzeug 41 angeordnet. Dieses dreht sich um eine Achse 50 und beschreibt dabei einen Drehkreis 51. Da hier innerhalb des Drehkreises kein Kammeragehäuse gelagert werden muss, ist die Anordnung an einem L-förmigen Dreharm nicht erforderlich. Die Bereitstellungsebene 7 bildet praktisch eine horizontale Tangente zum Drehkreis 45. Über der Bereitstellungsebene 7 erstreckt sich die Führungsschiene 21 für den Schlitten 15 des Sekundärwerkzeugs 8. In der in Figur 6 dargestellten Position hat das Sekundärwerkzeug 8 gerade einen Halbleiterchip vom Endschwenkwerkzeug 42 übernommen und transportiert diesen in Richtung der Ablagestation. Sämtliche Werkzeuge sind auf an sich bekannte Weise mit Aufnahmewerkzeugen versehen, wobei die für deren Betrieb erforderlichen pneumatischen Leitungen und Steuervorrichtungen nicht dargestellt sind.

Figur 7 zeigt die geometrische Beziehung der in Figur 6 dargestellten Werkzeuge zueinander und insbesondere den Kurvenverlauf eines Bauteils 1 zwischen der Ebene 47 der Vorratsstation und der Bereitstellungsebene 7. Die Drehachsen 13, 44 und 50 der Arbeitswerkzeuge bilden zueinander ein Dreieck, wobei sich die Drehkreise 14, 45 und 51 auf den Schenkeln des Dreiecks berühren bzw. annähernd berühren und dabei eine erste Übergabeposition 52, eine zweite Übergabeposition 53 und eine dritte Übergabeposition 54 bilden. Das Primärwerkzeug 6 legt ausgehend von der Aufnahmeposition 55 eine Schwenkbewegung zurück, die je nach Betriebsmodus über einen ersten Sektor S1 bis zur ersten Übergabeposition 52 oder über einen zweiten Sektor S2 bis zur zweiten Übergabeposition 53 führt. Das Zwischenschwenkwerkzeug 41 ist entweder inaktiv oder legt stets eine Schwenkbewegung zwischen der ersten Übergabeposition 52 und der dritten Übergabeposition 54 zurück. Das Endschwenkwerkzeug 42 legt je nach Betriebsmodus einen Schwenkweg zwischen der zweiten Übergabeposition 53 und der Abgabeposition 56 oder zwischen der dritten Übergabeposition 54 und der Abgabeposition 56 zurück. Ersichtlicherweise ist es je nach den konstruktiven Gegebenheiten möglich, die Radien der verschiedenen Drehkreise unterschiedlich auszubilden. Es wäre ausserdem denkbar, noch zusätzliche Schwenkwerkzeuge zu integrieren, sodass der Hub zwischen den beiden Ebenen 7 und 47 in mehreren Kurvenbewegungen zurückgelegt wird. Auch die entlang der Kurvenbahn angeordneten Zwischenablagestationen 40a, 40b könnten als Schwenkwerkzeuge ausgebildet werden, welche in der Lage sind, ein Bauteil wegzutransportieren.

Nachstehend wird anhand der Figuren 8 bis 10 die Funktionsweise und Anordnung der ersten Kamera 10 und der unteren zweiten Kamera 11a beschrieben. Die Kameras sind jeweils in einem länglichen Kameragehäuse 24 bzw. 24' angeordnet, welches in den Drehkreis des Primärwerkzeugs 6 bzw. des Endschwenkwerkzeugs 42 hineinragt. Bei der ersten Kamera 10 ist die Ausgangsöffnung 29 nach unten gegen die Ebene 47 der Vorratsstation gerichtet. Dem gegenüber ist bei der unteren zweiten Kamera 11a die Ausgangsöffnung 29' nach oben gegen die Bereitstellungsebene gerichtet. Die Bildumlenkung erfolgt jeweils an einem Umlenkspiegel 36. Je nach Arbeitsposition des am Dreharm 23 angeordneten Primärwerkzeug 6 bzw. des am Dreharm 43 angeordnetem Endschwenkwerkzeugs 42 wird der Bildbereich 37 jeweils für die entsprechende Kamera vollständig freigegeben.

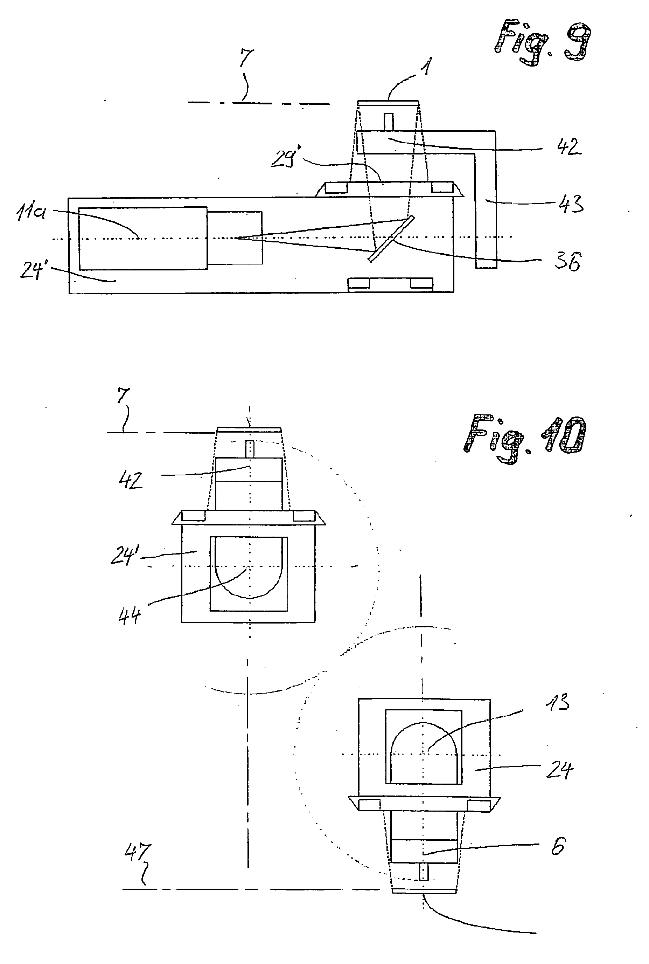

Insbesondere aus Figur 10 ist ersichtlich, dass entsprechend der Drehachsen 13 und 44 auch die jeweiligen optischen Achsen im Bereich der Ausgangsöffnungen der Kameras seitlich zueinander versetzt angeordnet sind. In bestimmten Fällen wäre es aber auch denkbar, dass die Drehachsen 13 und 44 und damit auch die optische Achse im Bereich der Ausgangsöffnung auf einer gemeinsamen vertikalen Achse angeordnet sind.

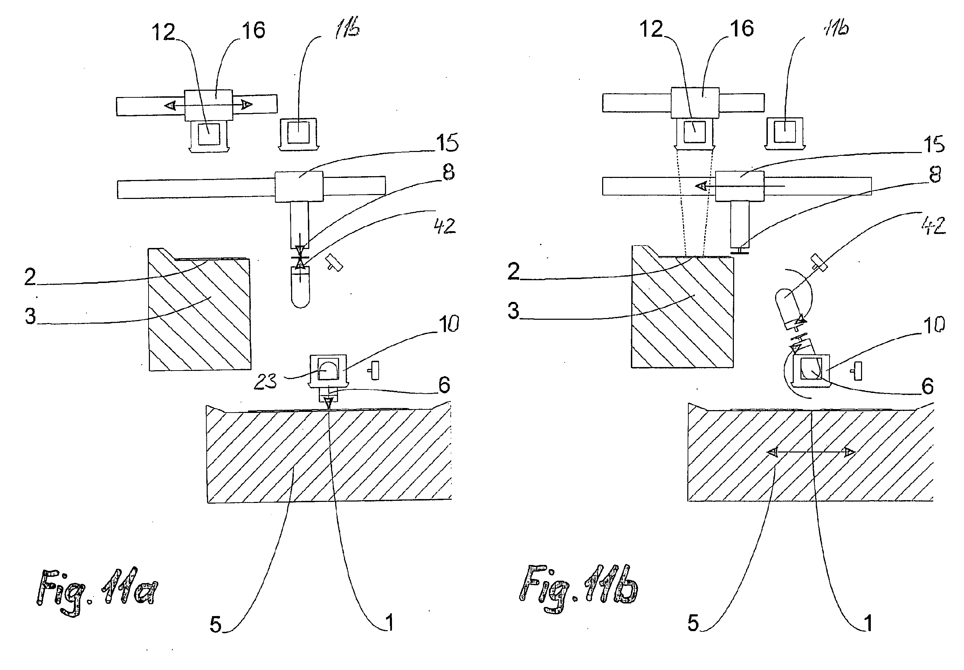

Nachstehend wird anhand der Figuren 11a bis 11e der Ablagevorgang eines Halbleiterchips beschrieben, bei dem der Chip mit der gleichen Auflageseite auf das Substrat aufgelegt wird, mit der er vorher auf der Waferfolie haftete (Nonflip-Anwendung). Gemäss Figur 11a steht der Dreharm 23 in einer vertikalen Position, in welcher das Primärwerkzeug 6 einen Halbleiterchip von der Vorratsstation 5 erfasst. Gleichzeitig übergibt das Endschwenkwerkzeug 42 einen bereits vorher geladenen Chip in der Bereitstellungsebene 7 dem Sekundärwerkzeug 8.

Gemäss Figur 11b drehen sich das Primärwerkzeug 6 und das Endschwenkwerkzeug 42 jeweils im Uhrzeigersinn aufeinander zu, während das Sekundärwerkzeug 8 am Schlitten 15 gegen die Ablagestation 3 bewegt wird. Vor dem Erreichen der Ablagestation wird mit der dritten Kamera 12 am Schlitten 16 die Istlage des Substrats 2 festgestellt.

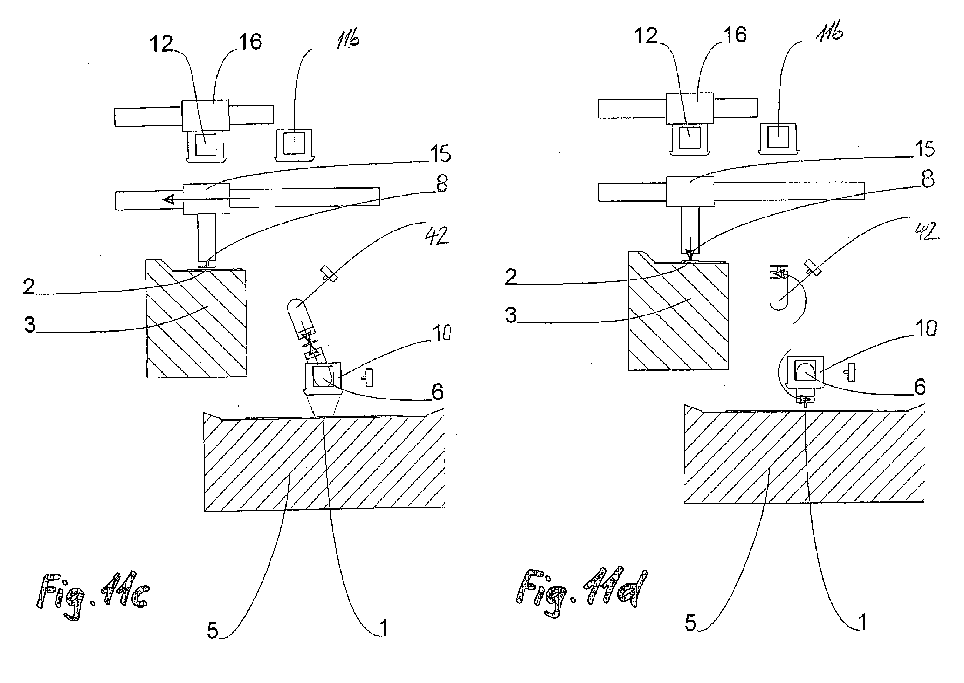

Gemäss Figur 11c hat das Sekundärwerkzeug 8 seine Abgabeposition über dem Substrat 2 erreicht. Das Primärwerkzeug 6 übergibt seinen Chip dem Endschwenkwerkzeug 42 und gleichzeitig wird mit Hilfe der ersten Kamera 10 der nächste aufzunehmende Chip 1 auf der Vorratsstätion 5 vermessen.

Gemäss Figur 11d hat das Sekundärwerkzeug 8 seinen Chip auf das Substrat 2 abgesetzt. Das Primärwerkzeug 6 ist im Gegenuhrzeigersinn in seine Aufnahmeposition zurückgekehrt. Ebenso wurde das Endschwenkwerkzeug 42 im Gegenuhrzeigersinn in seine Abgabeposition zurückgeschwenkt.

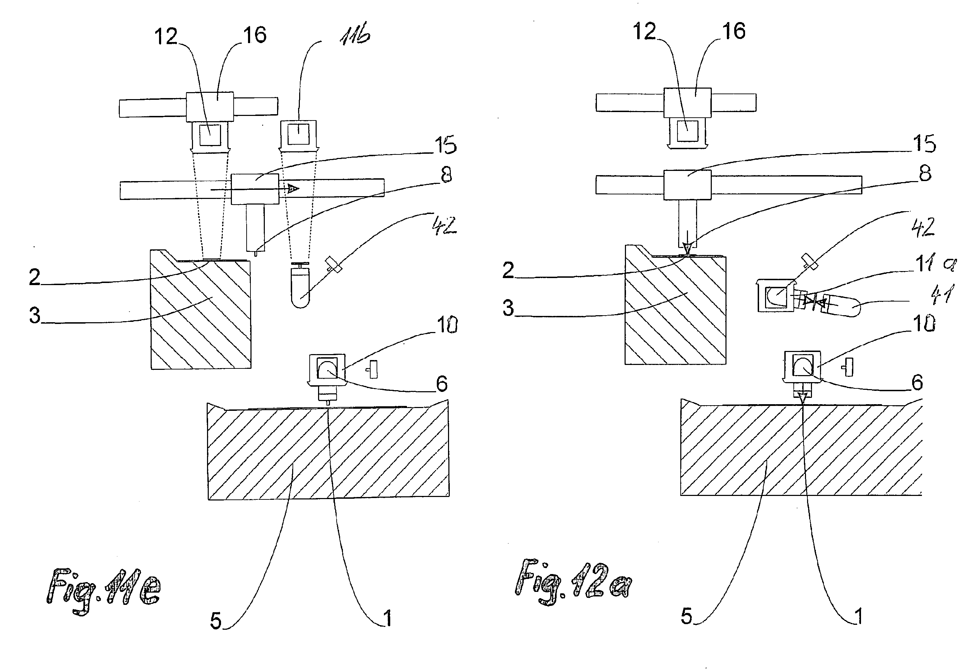

Schliesslich zeigt Figur 11e das leere Sekundärwerkzeug 8 auf seinem Weg zurück zur Aufnahme eines neuen Chips. Wie dargestellt, kann dabei in einer Zwischenposition sowohl die obere zweite Kamera 11b zur Ermittlung der Istlage des Chips am Endschwenkwerkzeug 42 als auch die dritte Kamera 12 zur Ermittlung der Istlage des Substrats 2 betätigt werden. Sobald das Sekundärwerkzeug 8 seine Ausgangslage erreicht hat, beginnt der Zyklus gemäss Figur 11a wieder von neuem. Aus Gründen der besseren Übersichtlichkeit wurden in den Figuren 11a bis 11e die nicht benötigte untere zweite Kamera 11a sowie das Zwischenschwenkwerkzeug 41 weggelassen.

Wird eine Ablage des Chips auf das Substrat mit seiner Strukturseite gewünscht (Flipchip-Anwendung), kann die Vorrichtung in einem anderen Betriebsmodus gefahren werden. Dabei wird die Zwischenschwenkvorrichtung 41 betätigt, wie aus den Figuren 12a bis 12e ersichtlich ist. Aus Gründen der besseren Übersichtlichkeit wurde in diesen Figuren die in diesem Betriebsmodus nicht benötigte obere zweite Kamera 11b weggelassen.

Gemäss Figur 12a wird vom Primärwerkzeug 6 ein Chip an der Vorratsstation 5 aufgenommen. Gleichzeitig wird vom Sekundärwerkzeug 8 ein Chip auf das Substrat 2 an der Ablagestation 3 abgesetzt. Das Endschwenkwerkzeug 42 empfängt vom Zwischenschwenkwerkzeug 41 einen vorher geladenen Chip. Die verschiedenen Kameras sind inaktiv.

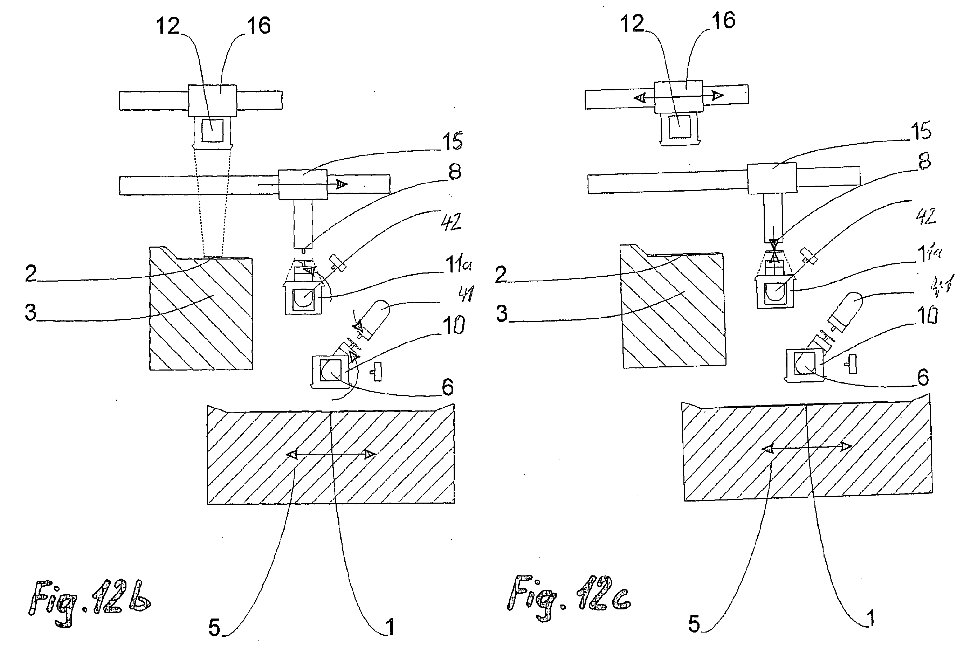

Gemäss Figur 12b wurde das Primärwerkzeug 6 mit seinem aufgenommenen Chip im Gegenuhrzeigersinn an die erste Übergabeposition geschwenkt. Ebenso wurde das Zwischenschwenkwerkzeug 41 im Gegenuhrzeigersinn zurückgeschwenkt, um einen neuen Chip aufnehmen zu können. Das Endschwenkwerkzeug hat den vorher geladenen Chip in die Abgabeposition zurückgeschwenkt und auch das Sekundärwerkzeug 8 hat seine Ausgangsposition wieder erreicht, in der es einen neuen Chip aufnehmen kann. Mit Hilfe der dritten Kamera 12 wird an der Abgabestation 3 die Istlage des neu zu bestückenden Substrats 2 vermessen.

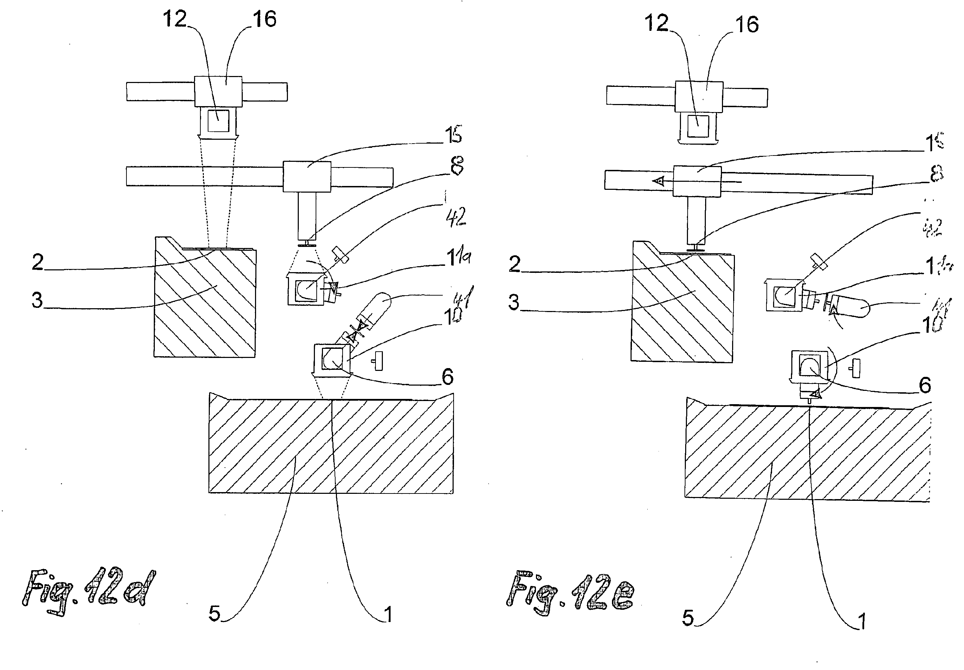

Gemäss Figur 12c wird der Chip am Endschwenkwerkzeug 42 an das Sekundärwerkzeug 8 übergeben. Das Primärwerkzeug 6 verharrt in der ersten Übergabeposition. Sobald gemäss Figur 12d das Endschwenkwerkzeug 42 wieder zurückschwenkt, kann mit der unteren zweiten Kamera 11a die Istlage des nun am Sekundärwerkzeug 8 fixierten Chips ermittelt werden. Gleichzeitig wird mit der ersten Kamera 10 die Istlage des nächsten abzuhebenden Chips an der Vorratsstation 5 ermittelt. Das Primärwerkzeug kann seinen vorher geladenen Chip an das Zwischenschwenkwerkzeug 41 übergeben. Schliesslich kann gemäss Figur 12e das Primärwerkzeug 6 wieder in seine Aufnahmeposition zurückschwenken. Ebenso fährt das Zwischenschwenkwerkzeug 41 seinen vorher geladenen Chip in die dritte Übergabeposition und das Sekundärwerkzeug 8 hat seine Abgabeposition über dem Substrat 2 erreicht. Anschliessend beginnt der Zyklus gemäss Figur 12a wieder von neuem.

## Patentansprüche

1. Verfahren zum Ablegen elektronischer Bauteile (1) insbesondere Halbleiterchips, auf einem Substrat (2) an einer Ablagestation (3), wobei das miL einer Auflageseite (4) an einer Vorratsstation (5) aufliegende Bauteil mit einem Primärwerkzeug (6) an einer von der Auflageseite abgewandten Strukturseite (17) erfasst, aufgenommen und durch eine Drehbewegung über die Ebene (47) der Vorratsstation transportiert wird und wobei das Bauteil von wenigstens einem Sekundärwerkzeug (8) in einer über der Ebene (47) der Vorratsstation liegenden Bereitstellungsebene (7) übernommen, über das Substrat transportiert und dort abgesetzt wird, wobei der Weg des Bauteils zwischen der Ebene (47) der Vorratsstation und der Bereitstellungsebene (7) in wenigstens zwei getrennten, aufsteigenden Kurvenbewegungen zurückgelegt wird, und wobei das Primärwerkzeug (6) das Bauteil in einer Übergabeposition wenigstens einem Schwenkwerkzeug (41, 42) übergibt.

2. Verfahren nach Anspruch 1, **dadurch gekennzeichnet, dass** das Primärwerkzeug (6) das Bauteil (1) einem Zwischenschwenkwerkzeug (41) übergibt, welches das Bauteil an der Auflageseite (4) erfasst und nach einer Schwenkbewegung einem Endschwenkwerkzeug (42) übergibt, welches das Bauteil wiederum an der Strukturseite (17) erfasst und in die Bereitstellungsebene (7) schwenkt, wo es dem Sekundärwerkzeug (8) übergeben wird, wobei es zuletzt mit der Strukturseite (17) auf das Substrat (2) abgesetzt wird.

3. Verfahren nach Anspruch 1, **dadurch gekennzeichnet, dass** das Primärwerkzeug (6) das Bauteil (1) direkt einem Endschwenkwerkzeug (42) übergibt, welches das Bauteil an der Auflageseite (4) erfasst und in die Bereitstellungsebene (7) schwenkt, wo es dem Sekundärwerkzeug (8) übergeben wird, wobei es zuletzt wieder mit der gleichen Auflageseite (4) auf das Substrat (2) abgesetzt wird.

4. Verfahren nach Anspruch 2 und Anspruch 3, **dadurch gekennzeichnet, dass** die Bauteile in einem ersten Betriebsmodus über das Zwischenschwenkwerkzeug (41) und in einem zweiten Betriebsmodus direkt dem Endschwenkwerkzeug (42) übergeben werden, wobei die Schwenkbewegung des Primärwerkzeugs (6) im ersten bzw. im zweiten Betriebsmodus ausgehend von der Aufnahme an der Vorratsstation vorzugsweise auf separaten Bewegungsabschnitten verläuft.

5. Verfahren nach einem der Ansprüche 1 bis 4, **dadurch gekennzeichnet, dass** die Kurvenbewegungen Teilkreisbogenbewegungen sind von denen vorzugsweise zwei aufeinander folgende gegensinnig gekrümmt verlaufen.

6. Verfahren nach einem der Ansprüche 1 bis 5, **dadurch gekennzeichnet, dass** die Bewegung des Sekundärwerkzeugs (8) von der Übernahme des Bauteils bis über das Substrat linear verläuft.

7. Verfahren nach einem der Ansprüche 1 bis 6, **dadurch gekennzeichnet, dass** der Transport des Bauteils (1) von der Vorratsstation (5) bis auf das Substrat (2) im Wesentlichen auf einer etwa vertikalen Transportebene verläuft.

8. Verfahren nach einem der Ansprüche 1 bis 7 **dadurch gekennzeichnet, dass** die Istlage des Bauteils auf der Vorratsstation (5) vor der Aufnahme mit einer ersten Bilderkennungseinrichtung (10) ermittelt wird und/oder dass die Istlage des Bauteils in der Bereitstellungsebene (7) vor dem Transport zum Substrat mit einer zweiten Bilderkennungseinrichtung (11a,11b) ermittelt wird, und/oder dass die Istlage des Substrats (2) mit einer dritten Bilderkennungseinrichtung (12) ermittelt wird, wobei Abweichungen zwischen den ermittelten Istwerten und einer vorbestimmten Solllage des Bauteils korrigiert werden.

9. Verfahren nach Anspruch 4 und Anspruch 8, **dadurch gekennzeichnet, dass** die Ermittlung der Istlage des Bauteils in der Bereitstellungsebene (7) durch die zweite Bilderkennungseinrichtung (11a,11b) im ersten Betriebsmodus von unten nach oben gegen das am Sekundärwerkzeug (8) gehaltene Bauteil und im zweiten Betriebsmodus von oben nach unten gegen das am Endschwenkwerkzeug (42) gehaltene Bauteil erfolgt.

10. Verfahren nach Anspruch 8 oder Anspruch 9, **dadurch gekennzeichnet, dass** die Ermittlung der Istlage mit je einer der Bilderkennungseinrichtungen immer dann erfolgt, wenn das Primärwerkzeug (6) bzw. das Sekundärwerkzeug (8) bzw. das Endschwenkwerkzeug (42) das Bildfeld der zu ermittelnden Istlage freigibt.

11. Vorrichtung zum Ablegen von elektronischen Bauteilen (1), insbesondere Halbleiterchips, auf einem Substrat (2) an einer Ablagestation (3) wobei das mit einer Auflageseite (4) an einer Vorratsstation (5) aufliegende Bauteil mit einem Primärwerkzeug (6) an einer von der Auflageseite abgewandten Strukturseite (17) aufnehmbar ist und mit dem das Bauteil über die Ebene (47) der Vorratsstation transportierbar ist, wobei das Bauteil von wenigstens einem Sekundärwerkzeug (8) in einer über der Ebene (47) der Vorratsstation liegenden Bereitstellungsebene (7) übernehmbar, über das Substrat (2) transportierbar und dort absetzbar ist, wobei ferner im Wirkbereich des Primärwerkzeugs (6) wenigstens ein Schwenkwerkzeug (41,42) angeordnet ist, an das ein Bauteil in einer Übergabeposition vom Primärwerkzeug (6) übergebbar ist, und wobei der Weg des Bauteils zwischen der Ebene (47) der Vorratsstation und der Bereitstcllungsebenc (7) in weinigstens zwei getrennten, aufsteigenden Kurvenbewegungen zurücklegbar ist.

12. Vorrichtung nach Anspruch (11), **dadurch gekennzeichnet, dass** im Wirkbereich des Primärwerkzeugs (6) ein Zwischenschwenkwerkzeug (41) und im Wirkbereich des Zwischenschwenkwerkzeugs ein Endschwenkwerkzeug (42) angeordnet ist und dass ein vom Primärwerkzeug (6) an der Strukturseite (17) erfasstes und angehobenes Bauteil durch das Zwischenschwenkwerkzeug an der Auflageseite (4) erfassbar und an das Endschwenkwerkzeug übergebar ist, wobei es von letzterem wieder an der Strukturseite (17) erfassbar und in die Bereitstellungsebene (7) schwenkbar ist, so dass es vom Sekundärwerkzeug (8) erfassbar und zuletzt mit der Strukturseite (17) auf das Substrat (2) absetzbar ist.

13. Vorrichtung nach Anspruch (11), **dadurch gekennzeichnet, dass** im Wirkbereich des Primärwerkzeugs (6) ein Endschwenkwerkzeug (42) angeordnet ist und dass ein vom Primärwerkzeug (6) an der Strukturseite (17) erfasstes und angehobenes Bauteil (1) durch das Endschwenkwerkzeug an der Auflageseite (4) erfassbar und in die Bereitstellungsebene (7) schwenkbar ist, sodass es vom Sekundärwerkzeug (8) erfassbar und zuletzt wieder mit der gleichen Auflageseite (4) auf das Substrat (2) absetzbar ist.

14. Vorrichtung nach Anspruch 12 und Anspruch 13, **dadurch gekennzeichnet, dass** sowohl das Zwischenschwenkwerkzeug (41) als auch das Endschwenkwerkzeug (42) im Wirkbereich des Primärwerkzeugs (6) angeordnet sind, wobei das Bauteil (1) alternativ in einem ersten Betriebsmodus über das Zwischenschwenkwerkzeug und in einem zweiten Betriebsmodus direkt über das Endschwenkwerkzeug auf die Bereitstellungsebene (7) transportierbar ist.

15. Vorrichtung nach Anspruch (14), **dadurch gekennzeichnet, dass** das Primärwerkzeug (6) im ersten Betriebsmodus in einem ersten Bewegungsabschnitt von der Aufnahmeposition an der Vorratsstation bis zur Übergabeposition an das Zwischenschwenkwerkzeug (41) und im zweiten Betriebsmodus in einem benachbarten zweiten Bewegungsabschnitt von der Aufnahmeposition an der Vorratsstation bis zur Übergabeposition an das Endschwenkwerkzeug (42) schwenkbar ist.

16. Vorrichtung nach einem der Ansprüche 11 bis 15, **dadurch gekennzeichnet, dass** das Primärwerkzeug (6) und das wenigstens eine Schwenkwerkzeug (41,42) derart schwenkbar sind, dass ein erfasstes Bauteil eine aus Kreisbogenabschnitten zusammengesetzte Kurvenbewegung ausführt.

17. Vorrichtung nach einem der Ansprüche 11 bis 16, **dadurch gekennzeichnet, dass** das Sekundärwerkzeug (8) an einem linear verschiebbaren Schlitten (15) angeordnet ist.

18. Vorrichtung nach einem der Ansprüche 11 bis 17, **dadurch gekennzeichnet, dass** das Primärwerkzeug (6), das wenigstens eine Schwenkwerkzeug (41,41) und das Sekundärwerkzeug (8) im Wesentlichen auf einer gemeinsamen, etwa vertikalen Transportebene bewegbar sind.

19. Vorrichtung nach einem der Ansprüche 11 bis 18, **dadurch gekennzeichnet, dass** für die Ermittlung der Istlage des Bauteils auf der Vorratsstation (5) vor der Aufnahme eine erste Bilderkennungseinrichtung (10) vorgesehen ist, und/oder dass für die Ermittlung der Istlage des Bauteils in der Bereitstellungsebene (7) vor dem Transport zum Substrat eine zweite Bilderkennungseinrichtung (11a,11b) vorgesehen ist, und/oder dass für die Ermittlung der Istlage des Substrats (2) eine dritte Bilderkennungseinrichtung (12) vorgesehen ist, wobei Abweichungen zwischen den ermittelten Istwerten und einer vorbestimmten Solllage des Bauteils korrigierbar sind.

20. Vorrichtung nach Anspruch 14 und nach Anspruch 19, **dadurch gekennzeichnet, dass** für die Ermittlung der Istlage des Bauteils in der Bereitstellungsebene (7) die zweite Bilderkennungseinrichtung (11a,11b) für den ersten Betriebsmodus unterhalb der Bereitstellungsebene von unten nach oben gerichtet und für den zweiten Betriebsmodus oberhalb der Bereitstellungsebene von oben nach unten gerichtet angeordnet ist.

21. Vorrichtung nach Anspruch 20, **dadurch gekennzeichnet, dass** je eine zweite Bilderkennungseinrichtung (11a, 11b) unterhalb und oberhalb der Bereitstellungsebene angeordnet ist, welche in Abhängigkeit vom Betriebsmodus alternativ aktivierbar sind.

22. Vorrichtung nach einem der Ansprüche 19 bis 21, **dadurch gekennzeichnet, dass** die Bilderkennungseinrichtungen derart positioniert sind, dass das Bildfeld der zu ermittelnden Istlage in wenigstens einer Betriebslage des Primärwerkzeugs (6), des wenigstens einen Schwenkwerkzeugs (41,42) und/oder des Sekundärwerkzeugs (8) vollständig erfassbar ist.

23. Vorrichtung nach einem der Ansprüche 20 oder 21 und Anspruch 22, **dadurch gekennzeichnet, dass** die erste Bilderkennungseinrichtung (10) derart angeordnet ist, dass die Erfassung des ihr zugeordneten Bildfeldes von innerhalb des Schwenkbereichs des Primärwerkzeugs (6) erfolgt und dass die zweite Bilderkennungseinrichtung (11a) für den zweiten Betriebsmodus derart angeordnet ist, dass die Erfassung des ihr zugeordneten Bildfeldes von innerhalb des Schwenkbereichs des Endschwenkwerkszeugs (42) erfolgt.

24. Vorrichtung nach einem der Ansprüche 19 bis 23, **dadurch gekennzeichnet, dass** die erste und die zweite Bilderkennungseinrichtung bzw. deren optische Achsen im Bereich der Ausgangsöffnung auf zueinander versetzten vertikalen Achsen angeordnet sind.

25. Vorrichtung nach einem der Ansprüche 19 bis 24, **dadurch gekennzeichnet, dass** die dritte Bilderkennungseinrichtung (12) an einem linear verschiebbaren Schlitten (16) angeordnet ist.

26. Vorrichtung nach einem der Ansprüche 11 bis 25, **dadurch gekennzeichnet, dass** die Ablagestation (3) als Zuführsystem für den vorzugsweise linearen Durchlauf einer Mehrzahl von Substraten ausgebildet ist.

27. Vorrichtung nach einem der Ansprüche 11 bis 26, **dadurch gekennzeichnet, dass** neben der Vorratsstation (5) eine Waferkassette (27) mit mehreren Wafern angeordnet ist, welche zum Laden von Wafern auf die Vorratsstation in verschiedene Ladepositionen bewegbar ist, in denen die Vorratsstation mit einem Wafer aus der Waferkassette beladbar und entladbar ist und dass die Waferkassette in eine Ruheposition bewegbar ist, in welcher die Vorrats station zum Abarbeiten eines geladenen Wafers wenigstens teilweise in der horizontalen Arbeitsebene über die Waferkassette verschiebbar ist.

28. Vorrichtung nach einem der Ansprüche 11 bis 27, **dadurch gekennzeichnet, dass** im Wirkbereich des Primärwerkzeugs (6) und/oder des wenigstens einen Schwenkwerkzeugs (41,42) eine oder mehrere Zwischenablagestationen (40a, 40b) angeordnet sind, an denen ein Bauteil vor der Übergabe an das Sekundärwerkzeug (8) vorübergehend ablegbar ist.

## Claims

1. A method for the placement of electronic components (1), in particular semiconductor chips, on a substrate (2) at a placement station (3), wherein the component bearing by a bearing side (4) at a supply station (5) is acquired by means of a primary tool (6) at a structure side (17) remote from the bearing side, is picked up and is transported by means of a rotational movement above the plane (47) of the supply station, and wherein the component is accepted by at least one secondary tool (8) in a provision plane (7) lying above the plane (47) of the supply station, is transported over the substrate and is deposited there, wherein the path of the component between the plane (47) of the supply station and the provision plane (7) is covered in at least two separate, ascending curve movements, wherein the primary tool (6) transfers the component to at least one pivoting tool (41, 42) in a transfer position.

2. The method as claimed in claim 1, **characterized in that** the primary tool (6) transfers the component (1) to an intermediate pivoting tool (41), which acquires the component at the bearing side (4) and, after a pivoting movement, transfers it to a final pivoting tool (42), which acquires the component at the structure side (17) again and pivots it into the provision plane (7), where it is transferred to the secondary tool (8), wherein it is finally deposited onto the substrate (2) by the structure side (17).

3. The method as claimed in claim 1, **characterized in that** the primary tool (6) transfers the component (1) directly to a final pivoting tool (42), which acquires the component at the bearing side (4) and pivots it into the provision plane (7), where it is transferred to the secondary tool (8), wherein it is finally deposited onto the substrate (2) once again by the same bearing side (4).

4. The method as claimed in claim 2 and claim 3, **characterized in that** the components are transferred to the final pivoting tool (42) via the intermediate pivoting tool (41) in a first operating mode and directly in a second operating mode, wherein the pivoting movement of the primary tool (6) in the first and in the second operating mode, respectively, proceeding from the pick-up at the supply station, preferably proceeds on separate movement sections.

5. The method as claimed in one of claims 1 to 4, **characterized in that** the curve movements are partial circle arc movements, of which preferably two successive movements proceed in a manner curved in opposite senses.

6. The method as claimed in one of claims 1 to 5, **characterized in that** the movement of the secondary tool (8) from the acceptance of the component as far as over the substrate proceeds linearly.

7. The method as claimed in one of claims 1 to 6, **characterized in that** the transport of the component (1) from the supply station (5) as far as onto the substrate (2) essentially proceeds on an approximately vertical transport plane.

8. The method as claimed in one of claims 1 to 7, **characterized in that** the actual position of the component on the supply station (5) prior to the pick-up is determined by means of a first image recognition device (10), and/or **in that** the actual position of the component in the provision plane (7) prior to the transport to the substrate is determined by means of a second image recognition device (11a, 11b), and/or **in that** the actual position of the substrate (2) is determined by means of a third image recognition device (12), wherein deviations between the actual values determined and a predetermined desired position of the component are corrected.

9. The method as claimed in claim 4 and claim 8, **characterized in that** the actual position of the component in the provision plane (7) is determined by the second image recognition device (11a, 11b) from below upward toward the component held at the secondary tool (8) in the first operating mode and from above downward toward the component held at the final pivoting tool (42) in the second operating mode.

10. The method as claimed in claim 8 or claim 9, **characterized in that** the actual position is determined by means of a respective one of the image recognition devices whenever the primary tool (6) or the secondary tool (8) or the final pivoting tool (42) clears the image field of the actual position to be determined.

11. An apparatus for the placement of electronic components (1), in particular semiconductor chips, on a substrate (2) at a placement station (3), wherein the component bearing by a bearing side (4) at a supply station (5) can be picked up by means of a primary tool (6) at a structure side (17) remote from the bearing side and by means of which the component can be transported above the plane (47) of the supply station, wherein the component can be accepted by at least one secondary tool (8) in a provision plane (7) lying above the plane (47) of the supply station, can be transported over the substrate (2) and can be deposited there, **characterized in that** at least one pivoting tool (41, 42) is arranged in the operative region of the primary tool (6), and a component can be transferred to said at least one pivoting tool from the primary tool (6) in a transfer position, wherein the path of the component between the plane (47) of the supply station and the provision plane (7) can be covered in at least two separate, ascending curve movements.

12. The apparatus as claimed in claim 11, **characterized in that** an intermediate pivoting tool (41) is arranged in the operative region of the primary tool (6) and a final pivoting tool (42) is arranged in the operative region of the intermediate pivoting tool, and **in that** a component which is acquired by the primary tool (6) at the structure side (17) and raised can be acquired by the intermediate pivoting tool at the bearing side (4) and can be transferred to the final pivoting tool, wherein it can be acquired by the latter once again at the structure side (17) and can be pivoted into the provision plane (7), with the result that it can be acquired by the secondary tool (8) and can finally be deposited onto the substrate (2) by the structure side (17).

13. The apparatus as claimed in claim 11, **characterized in that** a final pivoting tool (42) is arranged in the operative region of the primary tool (6), and **in that** a component (1) which is acquired by the primary tool (6) at the structure side (17) and raised can be acquired by the final pivoting tool at the bearing side (4) and can be pivoted into the provision plane (7), with the result that it can be acquired by the secondary tool (8) and can finally be deposited onto the substrate (2) once again by the same bearing side (4).

14. The apparatus as claimed in claim 12 and claim 13, **characterized in that** both the intermediate pivoting tool (41) and the final pivoting tool (42) are arranged in the operative region of the primary tool (6), wherein the component (1) can be transported to the provision plane (7) alternatively via the intermediate pivoting tool in a first operating mode and directly via the final pivoting tool in a second operating mode.

15. The apparatus as claimed in claim 14, **characterized in that** the primary tool (6) can be pivoted, in the first operating mode, in a first movement section from the pick-up position at the supply station as far as the transfer position to the intermediate pivoting tool (41) and, in the second operating mode, in an adjacent second movement section from the pick-up position at the supply station as far as the transfer position to the final pivoting tool (42).

16. The apparatus as claimed in one of claims 11 to 15, **characterized in that** the primary tool (6) and the at least one pivoting tool (41, 42) can be pivoted in such a way that an acquired component executes a curve movement composed of circle arc sections.

17. The apparatus as claimed in one of claims 11 to 16, **characterized in that** the secondary tool (8) is arranged at a linearly displaceable slide (15).

18. The apparatus as claimed in one of claims 11 to 17, **characterized in that** the primary tool (6), the at least one pivoting tool (41, 41) and the secondary tool (8) can be moved essentially on a common, approximately vertical transport plane.

19. The apparatus as claimed in one of claims 11 to 18, **characterized in that** a first image recognition device (10) is provided for determining the actual position of the component on the supply station (5) prior to the pick-up, and/or **in that** a second image recognition device (11a, 11b) is provided for determining the actual position of the component in the provision plane (7) prior to the transport to the substrate, and/or in that a third image recognition device (12) is provided for determining the actual position of the substrate (2), wherein deviations between the actual values determined and a predetermined desired position of the component can be corrected.

20. The apparatus as claimed in claim 14 and as claimed in claim 19, **characterized in that**, for determining the actual position of the component in the provision plane (7), the second image recognition device (11a, 11b) is arranged below the provision plane in a manner directed from below upward for the first operating mode and above the provision plane in a manner directed from above downward for the second operating mode.

21. The apparatus as claimed in claim 20, **characterized in that** a respective second image recognition device (11a, 11b) is arranged below and above the provision plane, which devices can be activated alternatively depending on the operating mode.

22. The apparatus as claimed in one of claims 19 to 21, **characterized in that** the image recognition devices are positioned in such a way that the image field of the actual position to be determined can be completely captured in at least one operating position of the primary tool (6), of the at least one pivoting tool (41, 42) and/or of the secondary tool (8).

23. The apparatus as claimed in one of claims 20 or 21 and claim 22, **characterized in that** the first image recognition device (10) is arranged in such a way that the image field assigned to it is captured from within the pivoting range of the primary tool (6), and **in that** the second image recognition device (11a), for the second operating mode, is arranged in such a way that the image field assigned to it is captured from within the pivoting range of the final pivoting tool (42).

24. The apparatus as claimed in one of claims 19 to 23, **characterized in that** the first and the second image recognition device or the optical axes thereof, in the region of the exit opening, are arranged on mutually offset vertical axes.

25. The apparatus as claimed in one of claims 19 to 24, **characterized in that** the third image recognition device (12) is arranged at a linearly displaceable slide (16).

26. The apparatus as claimed in one of claims 11 to 25, **characterized in that** the placement station (3) is embodied as a feed system for the preferably linear passage of a plurality of substrates.

27. The apparatus as claimed in one of claims 11 to 26, **characterized in that** a wafer cassette (27) with a plurality of wafers is arranged alongside the supply station (5) and can be moved, for the purpose of loading wafers onto the supply station, into different loading positions in which the supply station can be loaded with a wafer from the wafer cassette and can be unloaded, and **in that** the wafer cassette can be moved into a rest position in which the supply station, for processing a loaded wafer, can be displaced at least partly in the horizontal working plane over the wafer cassette.

28. The apparatus as claimed in one of claims 11 to 27, **characterized in that** one or a plurality of intermediate placement stations (40a, 40b) at which a component can be placed temporarily prior to the transfer to the secondary tool (8) are arranged in the operative region of the primary tool (6) and/or of the at least one pivoting tool (41, 42).

## Revendications

1. Procédé pour déposer des composants électroniques (1), en particulier des pastilles semi-conductrices, sur un substrat (2) à un poste de dépôt (3), le composant qui repose sur un poste de stockage (5) avec une face d'appui (4) étant saisi avec un outil primaire (6) sur une face structurée (17) opposée à la face d'appui, pris et transporté par un mouvement rotatif au-dessus du plan (47) du poste de stockage et le composant étant pris en charge par au moins un outil secondaire (8) dans un plan de mise à disposition (7) situé au-dessus du plan (47) du poste de stockage, transporté au-dessus du substrat et y étant déposé, le trajet du composant entre le plan (47) du poste de stockage et le plan de mise à disposition (7) étant parcouru en au moins deux mouvements curvilignes ascendants séparés et l'outil primaire (6) délivrant le composant dans une position de transfert à au moins un outil pivotant (41, 42).

2. Procédé selon la revendication 1, **caractérisé en ce que** l'outil primaire (6) délivre le composant (1) à un outil pivotant intermédiaire (41) qui saisit le composant sur la face d'appui (4) et le délivre, après un mouvement pivotant, à un outil pivotant terminal (42) qui, à son tour, saisit le composant sur la face structurée (17) et le pivote dans le plan de mise à disposition (7) où il est délivré à l'outil secondaire (8), cependant qu'il est finalement déposé avec la face structurée (18) sur le substrat (2).

3. Procédé selon la revendication 1, **caractérisé en ce que** l'outil primaire (6) délivre le composant (1) directement à un outil pivotant terminal (42) qui saisit le composant sur la face d'appui (4) et le pivote dans le plan de mise à disposition (7) où il est délivré à l'outil secondaire (8), cependant qu'il est finalement déposé à nouveau avec la même face d'appui (4) sur le substrat (2).

4. Procédé selon la revendication 2 et la revendication 3, **caractérisé en ce que** les composants sont délivrés dans un premier mode d'exploitation par l'outil pivotant intermédiaire (41) et dans un second mode d'exploitation directement à l'outil pivotant terminal (42), le mouvement pivotant de l'outil primaire (6) étant effectué dans le premier et/ou le second mode d'exploitation en partant de la prise au poste de stockage de préférence sur des sections de mouvement séparées.

5. Procédé selon l'une des revendications 1 à 4, **caractérisé en ce que** les mouvements curvilignes sont des mouvements en arc de cercle partiels dont de préférence deux d'entre eux successifs sont arqués en sens inverse.

6. Procédé selon l'une des revendications 1 à 5, **caractérisé en ce que** le mouvement de l'outil secondaire (8) est linéaire depuis la prise en charge du composant jusqu'au-dessus du substrat.

7. Procédé selon l'une des revendications 1 à 6, **caractérisé en ce que** le transport du composant (1) du poste de stockage jusqu'au substrat (2) se fait substantiellement sur un plan de transport approximativement vertical.

8. Procédé selon l'une des revendications 1 à 7, **caractérisé en ce que** la position réelle du composant au poste de stockage (5) est détectée avant la prise avec un premier dispositif de reconnaissance d'images (10) et/ou que la position réelle du composant dans le plan de mise à disposition (7) est détectée avant le transport vers le substrat avec un second dispositif de reconnaissance d'images (11 a, 11 b) et/ou que la position réelle du substrat (2) est détectée avec un troisième dispositif de reconnaissance d'images (12), des écarts entre les valeurs réelles détectées et une position nominale prédéterminée du composant étant corrigés.

9. Procédé selon la revendication 4 et la revendication 8, **caractérisé en ce que** la détection de la position réelle du composant dans le plan de mise à disposition (7) est effectuée par le second dispositif de reconnaissance d'images (11 a, 11b) dans le premier mode d'exploitation de bas en haut contre le composant tenu sur l'outil secondaire (8) et dans le second mode d'exploitation de haut en bas contre le composant tenu sur l'outil pivotant terminal (42).

10. Procédé selon la revendication 8 ou la revendication 9, **caractérisé en ce que** la détection de la position réelle est toujours effectuée avec respectivement l'un des dispositifs de reconnaissance d'images à chaque fois que l'outil primaire (6) ou l'outil secondaire (8) ou l'outil pivotant terminal (42) libère le champ d'images de la position réelle à détecter.

11. Dispositif pour déposer des composants électroniques (1), en particulier des pastilles semi-conductrices, sur un substrat (2) à un poste de dépôt (3), le composant qui repose sur un poste de stockage (5) avec une face d'appui (4) pouvant être pris avec un outil primaire (6) sur une face structurée (17) opposée à la face d'appui et avec lequel le composant peut être transporté au-dessus du plan (47) du poste de stockage, le composant pouvant être pris en charge par au moins un outil secondaire (8) dans un plan de mise à disposition (7) situé au-dessus du plan (47) du poste de stockage, pouvant être transporté au-dessus du substrat (2) et pouvant y être déposé, cependant qu'au moins un outil pivotant (41, 42) est, de plus, placé dans la zone d'action de l'outil primaire (6), outil pivotant auquel un composant peut être délivré dans une position de transfert par l'outil primaire (6) et le trajet du composant entre le plan (47) du poste de stockage et le plan de mise à disposition (7) pouvant être parcouru en au moins deux mouvements curvilignes ascendants séparés.

12. Dispositif selon la revendication 11, **caractérisé en ce qu'**un outil pivotant intermédiaire (41) est placé dans la zone d'action de l'outil primaire (6) et un outil pivotant terminal (42) est placé dans la zone d'action de l'outil pivotant intermédiaire et qu'un composant saisi et soulevé par l'outil primaire (6) sur la face structurée (17) peut être saisi par l'outil pivotant intermédiaire sur la face d'appui (4) et peut être délivré à l'outil pivotant terminal, cependant qu'il peut être saisi par celui-ci à nouveau sur la face structurée (17) et qu'il peut être pivoté dans le plan de mise à disposition (7) si bien qu'il peut être saisi par l'outil secondaire (8) et qu'il peut être finalement déposé avec la face structurée (17) sur le substrat (2).

13. Dispositif selon la revendication 11, **caractérisé en ce qu'**un outil pivotant terminal (42) est placé dans la zone d'action de l'outil primaire (6) et qu'un composant saisi et soulevé par l'outil primaire (6) sur la face structurée (17) peut être saisi par l'outil pivotant terminal sur la face d'appui (4) et peut être pivoté dans le plan de mise à disposition (7) si bien qu'il peut être saisi par l'outil secondaire (8) et qu'il peut être finalement déposé à nouveau avec la même face d'appui (4) sur le substrat (2).

14. Dispositif selon la revendication 12 et la revendication 13, **caractérisé en ce que** l'outil pivotant intermédiaire (41) aussi bien que l'outil pivotant terminal (42) sont placés dans la zone d'action de l'outil primaire (6), le composant (1) pouvant être transporté dans le plan de mise à disposition (7) au choix dans un premier mode d'exploitation par l'outil pivotant intermédiaire et dans un second mode d'exploitation directement par l'outil pivotant terminal.

15. Dispositif selon la revendication 14, **caractérisé en ce que** l'outil primaire (6) peut être pivoté, dans le premier mode d'exploitation, dans une première section de mouvement de la position de prise au poste de stockage à la position de transfert à l'outil pivotant intermédiaire (41) et dans le second mode d'exploitation, dans une seconde section de mouvement voisine, de la position de prise au poste de stockage à la position de transfert à l'outil pivotant terminal (42).

16. Dispositif selon l'une des revendications 11 à 15, **caractérisé en ce que** l'outil primaire (6) et l'outil pivotant qui existe au moins (41, 42) sont pivotants de telle manière qu'un composant qui a été saisi effectue un mouvement curviligne composé de sections d'arc de cercle.

17. Dispositif selon l'une des revendications 11 à 16, **caractérisé en ce que** l'outil secondaire (8) est placé sur un coulisseau (15) coulissant de manière linéaire.

18. Dispositif selon l'une des revendications 11 à 17, **caractérisé en ce que** l'outil primaire (6), l'outil pivotant qui existe au moins (41, 42) et l'outil secondaire (8) sont mobiles essentiellement sur un plan de transport commun, approximativement vertical.

19. Dispositif selon l'une des revendications 11 à 18, **caractérisé en ce qu'**un premier dispositif de reconnaissance d'images (10) est prévu pour la détection de la position réelle du composant au poste de stockage (5) avant la prise et/ou qu'un second dispositif de reconnaissance d'images (11 a, 11 b) est prévu pour la détection de la position réelle du composant dans le plan de mise à disposition (7) avant le transport au substrat et/ou qu'un troisième dispositif de reconnaissance d'images (12) est prévu pour la détection de la position réelle du substrat (2), des écarts entre les valeurs réelles détectées et une position nominale prédéterminée du composant étant corrigés.

20. Dispositif selon la revendication 14 et selon la revendication 19, **caractérisé en ce que**, pour la détection de la position réelle du composant dans le plan de mise à disposition (7), le second dispositif de reconnaissance d'images (11 a, 11 b) est placé, pour le premier mode d'exploitation, orienté de bas en haut en dessous du plan de mise à disposition et, pour le second mode d'exploitation, orienté de haut en bas au-dessus du plan de mise à disposition.

21. Dispositif selon la revendication 20, **caractérisé en ce qu'**un second dispositif de reconnaissance d'images (11 a, 11 b) est placé respectivement en dessous et au-dessus du plan de mise à disposition, ces dispositifs de reconnaissance d'image pouvant être activés au choix selon le mode d'exploitation.

22. Dispositif selon l'une des revendications 19 à 21, **caractérisé en ce que** les dispositifs de reconnaissance d'images sont positionnés de telle manière que le champ d'image de la position réelle à détecter peut être saisi entièrement dans au moins une position d'exploitation de l'outil primaire (6), de l'outil pivotant (41, 42) qui existe au moins et/ou de l'outil secondaire (8).

23. Dispositif selon l'une des revendications 20 ou 21 et selon la revendication 22, **caractérisé en ce que** le premier dispositif de reconnaissance d'images (10) est placé de telle manière que la détection du champ d'image qui lui est assigné se fait de l'intérieur de la zone de pivotement de l'outil primaire (6) et que le second dispositif de reconnaissance d'images (11 a) pour le second mode d'exploitation est placé de telle manière que la détection du champ d'image qui lui est assigné se fait de l'intérieur de la zone de pivotement de l'outil pivotant terminal (42).

24. Dispositif selon l'une des revendications 19 à 23, **caractérisé en ce que** le premier et le second dispositif de reconnaissance d'images ou leurs axes optiques sont placés dans la zone de l'ouverture de sortie sur des axes verticaux décalés l'un par rapport à l'autre.

25. Dispositif selon l'une des revendications 19 à 24, **caractérisé en ce que** le troisième dispositif de reconnaissance d'images (12) est placé sur un coulisseau (16) coulissant de manière linéaire.

26. Dispositif selon l'une des revendications 11 à 25, **caractérisé en ce que** le poste de dépôt (3) est configuré comme système d'alimentation pour le passage de préférence linéaire d'une multitude de substrats.

27. Dispositif selon l'une des revendications 11 à 26, **caractérisé en ce qu'**une cassette de plaquettes de silicium (27) avec plusieurs plaquettes de silicium est placée près du poste de stockage (5), cassette qui peut être déplacée pour charger des plaquettes de silicium au poste de stockage dans différentes positions de chargement dans lesquelles le poste de stockage peut être chargé avec une plaquette de silicium de la cassette de plaquettes de silicium et déchargé et que la cassette de plaquettes de silicium peut être déplacée dans une position de repos dans laquelle le poste de stockage peut, pour prendre en charge une plaquette de silicium chargée, être déplacé au-dessus de la cassette de plaquettes de silicium au moins partiellement dans le plan de travail horizontal.

28. Dispositif selon l'une des revendications 11 à 27, **caractérisé en ce qu'**un ou plusieurs postes de dépôt intermédiaire (40a, 40b) sont placés dans la zone d'action de l'outil primaire (6) et/ou de l'outil pivotant (41, 42) qui existe au moins, postes auxquels un composant peut être déposé provisoirement avant le transfert à l'outil secondaire (8).
